# EUROPÄISCHE PATENTSCHRIFT

(11) **EP 2 369 600 B1**
(45) Veröffentlichungstag und Bekanntmachung des Hinweises auf die Patenterteilung: **29.08.2012**
(21) Anmeldenummer: 10305216.3
(22) Anmeldetag: 04.03.2010
(51) Int. Cl.: H01B 12/06

(54) **Supraleitfähiges elektrisches Gleichstrom-Kabel**
Direct current supraconductor cable
Câble supraconducteur pour courant continu

(43) Veröffentlichungstag der Anmeldung: 28.09.2011
(73) Patentinhaber: Nexans, 75008 Paris (FR)
(72) Erfinder: Dr.-Ing. Stemmle, Mark, 30161, Hannover (DE); Dr.-Ing. Marzahn, Erik, 30853, Langenhagen (DE)
(74) Vertreter: Döring, Roger

(56) Entgegenhaltungen:
- EP-A2- 0 451 864
- WO-A1-2008/148390
- JP-A- 5 062 536
- DATABASE WPI Week 199209 Thomson Scientific, London, GB; AN 1992-068848 XP002584664 -& JP 04 012412 A (JAPAN ATOMIC ENERGY RES INST) 17. Januar 1992 (1992-01-17)

## Beschreibung

Die Erfindung bezieht sich auf ein supraleitfähiges elektrisches Gleichstrom-Kabel gemäß dem Oberbegriff des Patentanspruchs 1.

Ein solches Kabel geht aus der WO 2008/148390 A1 hervor.

Supraleitfähige Kabel haben in heutiger Technik elektrische Leiter aus einem Verbundwerkstoff, welcher keramisches Material enthält, das bei ausreichend tiefen Temperaturen in den supraleitfähigen Zustand übergeht. Der elektrische Gleichstromwiderstand eines entsprechend aufgebauten Leiters ist bei ausreichender Kühlung Null, solange eine bestimmte Stromstärke nicht überschritten wird. Geeignete keramische Materialien sind beispielsweise BSCCO (Wismut-Strontium-Kalzium-Kupfer-Oxid) als Material der 1. Generation oder ReBCO (Rareearth-Barium-Kupfer-Oxid), insbesondere YBCO (Yttrium-Barium-Kupfer-Oxid), als Materialien der 2. Generation. Ausreichend niedrige Temperaturen, um ein derartiges Material in den supraleitfähigen Zustand zu bringen, liegen beispielsweise zwischen 67 K und 90 K. Geeignete Kühlmittel sind beispielsweise Stickstoff, Helium, Neon und Wasserstoff oder Gemische dieser Stoffe.

Ein Gleichstrom-Kabel, im folgenden kurz "Kabel" genannt, wie es eingangs beschrieben ist, kann beispielsweise als Stromversorgungskabel auf Schiffen oder als Verbindungskabel zwischen Knotenpunkten innerhalb eines Übertragungsnetzes sowie auch als Verbindungskabel zwischen unterschiedlichen Übertragungsnetzen eingesetzt werden. Dabei kann es sich beispielsweise um eine Anordnung für eine Hochspannungsgleichstromübertragung (HGÜ) handeln, die zur Überbrückung langer Strecken verwendet werden kann, beispielsweise als Seekabel. Gegenüber supraleitfähigen Wechselstromkabeln haben supraleitfähige Gleichstrom-Kabel den Vorteil, daß keine elektrischen Wechselstromverluste entstehen. Außerdem werden die Gleichstrom-Kabel nicht mit Ladeströmen belastet und es treten keine unerwünschten induktiven Spannungsabfälle auf.

Aus der eingangs erwähnten WO 2008/148390 A1 geht ein zweiphasiges elektrisches Kabel zur Stromversorgung von Verbrauchern elektrischen Stroms hervor. Es ist als supraleitfähiges Kabel mit zwei Phasenleitern ausgeführt, die koaxial zueinander und durch ein inneres Dielektrikum voneinander getrennt zu einer Einheit zusammengefaßt sind. Das Kabel ist in einem Kryostat angeordnet, der aus zwei konzentrischen Rohren besteht, zwischen denen eine Vakuumisolierung angebracht ist. Das Kühlmittel zur Erzeugung des supraleitfähigen Zustands der Phasenleiter wird durch den Kryostat geleitet. Die Kühlung eines solchen Kabels ist problematisch, weil für die Kühlung der supraleitfähigen Phasenleiter das Dielektrikum eine thermische Isolierung darstellt.

Der Erfindung liegt die Aufgabe zugrunde, das eingangs geschilderte Kabel so zu gestalten, daß bei vereinfachtem Aufbau eine gute Kühlung der supraleitfähigen Leiter möglich ist.

Diese Aufgabe wird entsprechend den kennzeichnenden Merkmalen des Patentanspruchs 1 gelöst.

Dieses Kabel ist einfach und kompakt aufgebaut. Jeder Leiter besteht aus einer Vielzahl von supraleitfähigen Elementen, die im Außenbereich des Trägers liegen, so daß dieselben bzw. der jeweilige Leiter von einem durch den Kryostat bewegten Kühlmittel direkt gekühlt werden. Die Anzahl der supraleitfähigen Elemente ist leicht veränderbar, so daß das Kabel auf einfache Art und Weise an unterschiedliche Stromstärken angepaßt werden kann, mit entsprechend variablem Bedarf an supraleitfähigem Material. Der Aufbau des Kabels kann modulartig durch eine unterschiedliche Anzahl von Nuten verändert werden, in denen jeweils eine Vielzahl von supraleitfähigen Elementen untergebracht wird. Eine erhöhte Anzahl von Nuten ist stets ein ganzzahliges Vielfaches von "2". Durch die räumliche Nähe der Leiter ist das äußere Magnetfeld des Kabels minimiert. Das Kabel ist insgesamt durch den Kryostat thermisch isoliert.

In bevorzugter Ausführungsform verlaufen die Nuten in Längsrichtung des Trägers wendelförmig um denselben herum.

Ausführungsbeispiele des Erfindungsgegenstandes sind in den Zeichnungen dargestellt.

Es zeigen:
Fig. 1 ein in einem Kryostat angeordnetes Kabel nach der Erfindung.
Fig. 2 eine gegenüber Fig. 1 abgewandelte Ausführungsform des Kabels.
Fig. 3 und 4 Einzelheiten des Kabels nach Fig. 1 oder 2 in vergrößerter Darstellung.

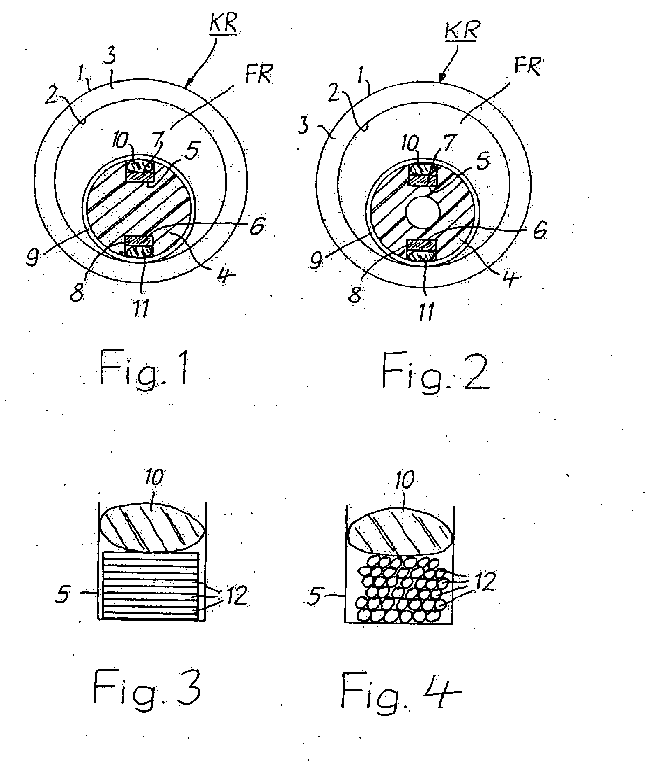

In den Fig. 1 und 2 ist das supraleitfähige Kabel nach der Erfindung jeweils mit nur zwei m Leitern dargestellt. Es können auch mehr Leiter sein, mit einem ganzzahligen Vielfachen von "2".

Im Ausführungsbeispiel nach Fig. 1 ist ein Kryostat KR dargestellt, der aus zwei koaxial zueinander angeordneten metallischen Rohren 1 und 2 besteht, zwischen denen sich eine Vakuumisolierung 3 befindet. Der Kryostat KR könnte auch einen anderen Aufbau haben, wenn sichergestellt ist, daß der von ihm umschlossene Raum wirksam gegen Wärmeeinfall von außen geschützt ist. Im Kryostat KR ist als Teil des Kabels ein aus Isoliermaterial bestehender, strangförmiger Träger 4 angebracht, der gegenüber dem inneren Rohr 2 des Kryostats KR einen Freiraum FR zum Durchleiten eines Kühlmittels frei läßt. Das Isoliermaterial des Trägers 4 muß bei den niedrigen Temperaturen des im Betriebsfall eingesetzten Kühlmittels beständig sein. Eine entsprechende Temperatur liegt gemäß den obigen Ausführungen beispielsweise zwischen 67 K und 90 K. Ein geeignetes Isoliermaterial ist beispielsweise Polytetrafluorethylen.

Der Träger 4 ist im Querschnitt kreisrund dargestellt. Er kann aber auch eine andere geometrische Querschnittsform haben, beispielsweise eine polygone. Im Träger 4 sind zwei nach außen offene Nuten 5 und 6 angebracht, die einander diametral gegenüber liegen. Sie verlaufen mit Vorteil wendelförmig um den Träger 4 herum.

In den Nuten 5 und 6 des Trägers 4 sind als Phasenleiter eines supraleitfähigen Kabels elektrische Leiter 7 und 8 aus supraleitfähigem Material angeordnet. Ihr Aufbau geht in genauerer Darstellung aus den Fig. 3 und 4 hervor. Um den Träger 4 herum ist auf seiner ganzen axialen Länge vorzugsweise eine Haltewendel 9 aus Isoliermaterial angebracht, durch welche ein Heraustreten der Leiter 7 und 8 aus den Nuten 5 und 6 verhindert wird. Zusätzlich können auch aus Isoliermaterial bestehende Verschlußelemente 10 und 11 radial über den Leitern 7 und 8 in den Nuten 5 und 6 angebracht sein, die gegebenenfalls von der Haltewendel 9 mit umschlossen werden. Die Haltewendel 9 und die Verschlußelemente 10 und 11 bestehen mit Vorteil aus dem gleichen Material wie der Träger 4.

Der Träger 4 ist in Fig. 1 als massiver Strang dargestellt. Er kann gemäß Fig. 2 aber auch als Rohr ausgeführt sein, durch welches beim Betrieb des Kabels das im Freiraum FR geführte Kühlmittel ebenfalls bzw. zusätzlich hindurchgeleitet werden kann. Der sonstige Aufbau des Trägers 4 nach Fig. 2 entspricht dem des Trägers nach Fig. 1.

Die Leiter 7 und 8 des Kabels bestehen jeweils aus einer Vielzahl von supraleitfähigen Elementen mit kleineren Querschnittsabmessungen, so wie es aus den Fig. 3 und 4 hervorgeht:

Die supraleitfähigen Elemente 12 der Leiter 7 und 8 können gemäß Fig. 3 als flache Streifen ausgeführt sein, die in einem Stapel übereinander liegend angeordnet sind. Sie können durch ein um den Stapel herumgewickeltes Band locker zusammengehalten sein. Das gilt auch bei der Ausführungsform der Leiter 7 und 8 nach Fig. 4, bei welcher eine Einheit aus runden Drähten als supraleitfähige Elemente 12 eingesetzt ist.

Die vorangehenden Ausführungen gelten-wie schon erwähnt- auch für Kabel mit mehr als zwei supraleitfähigen Leitern 7 und 8, wobei die Anzahl der Leiter jeweils ein ganzzahliges Vielfaches von "2" ist.

## Patentansprüche

1. Supraleitfähiges elektrisches Gleichstrom-Kabel mit mindestens zwei gegeneinander isolierten Leitern, welches für seinen Betrieb in einem zur Führung eines Kühlmittels geeigneten Kryostat anbringbar ist, der aus mindestens einem metallischen Rohr besteht, das von einer rundum geschlossenen Schicht mit wärmeisolierenden Eigenschaften umgeben ist, **dadurch gekennzeichnet,**
- **daß** das Gleichstrom-Kabel einen aus Isoliermaterial bestehenden, strangförmigen Träger (4) aufweist, der mindestens zwei einander diametral gegenüber liegende, nach außen offene Nuten (5,6) hat, in denen jeweils einer der Leiter (7,8) angeordnet ist, und
- **daß** jeder Leiter (7,8) aus einer Vielzahl von supraleitfähigen Elementen (12) besteht.

2. Kabel nach Anspruch 1, **dadurch gekennzeichnet, daß** die supraleitfähigen Elemente (12) flache Streifen sind.

3. Kabel nach Anspruch 1, **dadurch gekennzeichnet, daß** die supraleitfähigen Elemente (12) runde Drähte sind.

4. Kabel nach einem der Ansprüche 1 bis 3, **dadurch gekennzeichnet, daß** um den mit Leitern (7,8) bestückten Träger (4) eine Haltewendel (9) aus Isoliermaterial herumgewickelt ist.

5. Kabel nach einem der Ansprüche 1 bis 3, **dadurch gekennzeichnet, daß** die Nuten (5,6) durch radial über den Leitern (7,8) liegende Verschlußelemente aus Isoliermaterial verschlossen sind.

6. Kabel nach einem der Ansprüche 1 bis 5, **dadurch gekennzeichnet, daß** der Träger (4) ein massiver Strang ist.

7. Kabel nach einem der Ansprüche 1 bis 5, **dadurch gekennzeichnet, daß** der Träger (4) ein Rohr ist.

## Claims

1. Superconductive electrical direct current cable with at least two conductors insulated relative to each other, which in the operation status is mounted in a cryostat suitable for conducting a cooling agent, wherein the cryostat comprises at least one metal pipe, which is surrounded by a circumferentially closed layer with thermal insulating properties, **characterized in**
- **that** the direct current cable has a strand-shaped carrier (4) of insulating material which has at least two grooves (5,6) located diametrically opposite each other, wherein the grooves are open outwardly and in each groove is arranged one of the conductors, and
- **that** each conductor (7,8) is composed of a plurality of superconductive elements (12).

2. Cable according to claim 1, **characterized in that** the superconductive elements (12) are flat strips.

3. Cable according to claim 1, **characterized in that** the superconductive elements (12) are round wires.

4. Cable according to one of the claims 1 to 3, **characterized in that** a holding helix (9) of insulating material is wound around the carrier (4) equipped with a conductor (7,8).

5. Cable according to one of the claims 1 to 3, **characterized in that** the grooves (5,6) are closed by closing elements of insulating material placed radially above the conductor (7,8).

6. Cable according to one of the claims 1 to 5, **characterized in that** the carrier (4) is a solid strand

7. Cable according to one of the claims 1 to 5, **characterized in that** the carrier (4) is a tube.

## Revendications

1. Câble électrique supraconducteur pour courant continu, doté d'au moins deux conducteurs isolés l'un de l'autre et qui, en fonctionnement, peut être placé dans un cryostat qui convient pour amener un fluide de refroidissement, le cryostat étant constitué d'au moins un tube métallique entouré par une couche périphérique fermée à propriétés d'isolation thermique, **caractérisé en ce**
- **que** le câble à courant continu présente un support (4) en forme de barre constitué d'un matériau isolant qui possède au moins deux rainures (5, 6) ouvertes vers l'extérieur et diamétralement opposées dans chacune desquelles l'un des conducteurs (7, 8) est disposé et
- **que** en ce que chaque conducteur (7, 8) est constitué de plusieurs éléments supraconducteurs (12).

2. Câble selon la revendication 1, **caractérisé en ce que** les éléments supraconducteurs (12) sont des rubans plats.

3. Câble selon la revendication 1, **caractérisé en ce que** les éléments supraconducteurs (12) sont des fils ronds.

4. Câble selon l'une des revendications 1 à 3, **caractérisé en ce qu'**une spirale de maintien (9) en matériau isolant est enroulée autour du support (4) équipé des conducteurs (7, 8).

5. Câble selon l'une des revendications 1 à 3, **caractérisé en ce que** les rainures (5, 6) sont fermées par des éléments de fermeture en matériau isolant disposés radialement au-dessus des conducteurs (7, 8).

6. Câble selon l'une des revendications 1 à 5, **caractérisé en ce que** le support (4) est un barreau massif.

7. Câble selon l'une des revendications 1 à 5, **caractérisé en ce que** le support (4) est un tube.
